# EUROPEAN PATENT APPLICATION

(11) **EP 1 944 801 A1**
(43) Date of publication of application: **16.07.2008**
(21) Application number: 07011442.6
(22) Date of filing: 12.06.2007
(51) Int. Cl.: H01L 21/8238, H01L 21/8234

(54) **Methods for manufacturing a CMOS device with dual work function**

(30) Priority: 10.01.2007 US 879635 P
(71) Applicant: Interuniversitair Microelektronica Centrum, 3001 Leuven (BE); Taiwan Semiconductor Manufacturing Co., Ltd., 300-077 HsinChu (TW)
(72) Inventor: Chang, Shou-Zen, B-3080 Tervuren (BE); Yu, HongYu, B-3001 Leuven (BE); Veloso, Anabela, B-3001 Leuven (BE); Vos, Rita, B-3128 Tremelo (BE); Kubicek, Stefan, B-3212 Pellenberg (BE); Biesemans, Serge, B-3000 Leuven (BE); Singanamalla, Raghumath, B-3001 Heverlee (BE); Lauwers, Anne, B-2630 Aartselaar (BE); Onsia, Bart, B-1030 Schaarbeek (BE)
(74) Representative: Bird, William Edward

(57) **Abstract**

The present invention provides a method for manufacturing a dual workfunction semiconductor device. The method comprises providing a device on a first region and a device on a second region of a substrate. According to embodiments of the present invention, this is done by
- providing a dielectric layer onto the first and second region of the substrate, the dielectric layer on the first region being integrally deposited with the dielectric layer on the second region, and
- providing a gate electrode (17) on top of the dielectric layer on both the first and second regions, the gate electrode on the first region being integrally deposited with the gate electrode on the second region.

The method according to embodiments of the first aspect of the present invention further comprises
changing the workfunction of the device on the first region by providing a capping layer (15) onto the first region (I) between the dielectric layer and the gate electrode (17), and
changing the workfunction of the device on the second region (II) by including species at the interface between the dielectric layer (14) and the electrode (17).

A corresponding dual workfunction semiconductor device is also provided.

## Description

### TECHNICAL FIELD OF THE INVENTION

The present invention relates to methods for manufacturing a CMOS device with dual work function.

### BACKGROUND OF THE INVENTION

In order to make CMOS devices, one needs two distinctly different work functions (WF) for N-MOS and P-MOS transistor gate respectively. As the gate work function is mainly determined by the material used for the gate electrode, this dual work function requirement usually implies the use of two different materials, in particular two different metals, for a given gate dielectric. The process flow or integration of such dual metal approach is quite cumbersome and includes a large number of process steps.

### SUMMARY OF THE INVENTION

With regard to the present invention, methods are disclosed to form a CMOS device with dual work function, the methods providing a simplified process flow with reduced number of process steps. For both P- MOS and N-MOS transistors it is proposed to use the same material for the gate electrodes and to adjust the work function of the respective transistor gates. This may be done by (1) implantation of the gate dielectric or (2) insertion of a dielectric capping layer in between the gate electrode and the host gate dielectric material; and/or (3) implantation of the host gate electrode prior to fully silicided (FUSI) gate formation. Embodiments of the present invention may be applied in particular to devices with FUSI gates.

In a first aspect, the present invention provides a method for manufacturing a dual workfunction semiconductor device. The method comprises providing a device on a first region and a device on a second region of a substrate. According to embodiments of the present invention, this is done by
- providing a dielectric layer onto the first and second region of the substrate, the dielectric layer on the first region being integrally deposited with the dielectric layer on the second region and therefore having the same properties, e.g. same material, same thickness, etc., and
- providing a gate electrode on top of the dielectric layer on both the first and second regions, the gate electrode on the first region being integrally deposited with the gate electrode on the second region and therefore having the same properties, e.g. same material, same thickness, etc.
The method according to embodiments of the first aspect of the present invention further comprises
changing the workfunction of the device on the first region by providing a capping layer onto the first region between the dielectric layer and the gate electrode, and
changing the workfunction of the device on the second region by including species at the interface between the dielectric layer and the electrode.

An advantage of embodiments of the present invention is that no selective removal of gate material is required. A common conductive, e.g. metal or FUSI, gate electrode may be used for both nmos and pmos devices. This reduces or even eliminates potential problems at the N+/P+ boundary compared to prior art methods when a dual-phase FUSI CMOS scheme - e.g. NiSi for nmos and Ni-rich for pmos - is used. In the latter case, the length of the interface between NiSi (nmos) and Ni-rich (pmos- gate electrodes can be of concern for very high density applications. In case of a common (i.e. same phase) FUSI electrode for both nmos and pmos, as in accordance with embodiments of the present invention, this problem/concern is solved. Furthermore, use of Ni-rich FUSI for both nmos and pmos leads to a higher process window for the FUSI CMOS integration process, hence with further advantages for manufacturability.

In accordance with embodiments of the present invention, the workfunction is thus changed by adapting the gate dielectric. This may be done by capping and implanting as described in more detail below, while keeping the equivalent oxide thickness (EOT) low, preferably as low as possible. This EOT requirement implies that not just anything can be deposited or implanted.

In embodiments of the present invention, the device on the first region is an N-MOS device. In embodiments of the present invention, the device on the second region is a P-MOS device.

In embodiments of the present invention, including species at the interface between the dielectric layer and the electrode may be performed before providing the gate electrode on top of the dielectric layer. In alternative embodiments, including species at the interface between the dielectric layer and the electrode may be performed after electrode formation.

A method according to embodiments of the present invention may furthermore comprise providing a capping layer onto the second region between the dielectric layer and the gate electrode. This way, a double capping is provided for protection of the dielectric layer during implantation.

A method according to embodiments of the present invention may furthermore comprise providing a further capping layer for protecting the gate integrity during processing of the devices.

In a method according to embodiments of the present invention, including species at the interface between the dielectric layer and the electrode may comprise introducing species by ion implantation. The introduced species are work-function tuning elements. Introducing species by ion implantation comprises providing a resist layer on specific locations of the dielectric layer, and performing ion implantation in regions not covered by the resist layer.

A method according to embodiments of the present invention may further comprise tuning of pre and/or post capping layer deposition nitridation conditions for further tuning the workfunction of the semiconductor device.

In a method according to embodiments of the present invention, capping may be performed by means of DyO. Such DyO capping layer may be removed by means of a selective wet etch. The selective wet etch may be performed by means of a HCl-based solution with a low pH. The pH-value of the selective wet etch solution can be lower than 5, more preferably between 2 and 4.

In a method according to embodiments of the present invention, the gate electrode may be a FUSI electrode.

In a second aspect, embodiments of the present invention provide a method for removing a DyO layer, the method comprising performing a selective wet etch. The selective wet etch may be performed by means of a HCl-based solution. Advantageous is that such HCl-based solution allows to selectively etch the DyO layer, a.o. towards HfSiON or SiON layers.

In a third aspect, the present invention provides a dual workfunction semiconductor device, comprising semiconductor devices of a first type and semiconductor devices of a second type. Each semiconductor device comprises:
- a gate dielectric on a substrate, and
- a gate electrode on the gate dielectric,
wherein the gate electrodes of the semiconductor devices of the first type are integrally deposited with the gate electrodes of the semiconductor devices of the second type, and therefore having the same properties, e.g. same material, same thickness, etc., and
wherein the gate dielectric of the semiconductor devices of the first type is different from the gate dielectric of the semiconductor devices of the second type in that it is made of a same basic material, but including different species at the interface between the dielectric layer and the electrode.

### BRIEF DESCRIPTION OF THE DRAWINGS

In Figs 1 to 8 and figs 9 to 16 two process integration flows are schematically represented. Each process flow comprises the steps of gate dielectric implantation followed by high-k cap layer deposition and selective removal of this high-k cap layer.
Fig. 17 and Fig 18 illustrate gate dielectric implantation through the unpatterned gate electrode on region II (pmos) according to an embodiment of the present invention.
Fig. 19 and Fig. 20 illustrate gate dielectric implantation through the unpatterned gate electrode on region I (nmos) according to an embodiment of the present invention.
Fig. 21 illustrates the etch rate of 10 nm thick layers of DyO, DyScO and LaO, respectively, in acidified solutions, in particular in diluted HCl.
Fig. 22 illustrates the compatibility of DUV resist with HCL and HF/HCl chemistry. In Fig. 18 (a) shows an untreated sample, (b) shows a sample treated with HF/HCl, and (c) shows a sample treated with HCl.
Fig. 23 illustrates the removal of Dy-containing oxides in dHCl (3.6 w/w %) at a temperature of 25°C in a SW spray tool.
Fig. 24 illustrates the compatibility of high-k layers with dHCl (3.6 w/w %) at a temperature of 25°C in a SW spray tool.
Fig. 25 illustrates the compatibility of high-k layers and high-k cap layers with microstrip 2001 at 80°C in a beaker set-up.
Fig. 26 plots the workfunction WF (Vfb) of a Ni FUSI electrode on HfSiON capped with DyO in accordance with embodiments of the present invention.
Fig. 27 shows an XTEM of a NiSi FUSI/DyO/HfSiON gate stack in accordance with embodiments of the present invention.
Fig. 28 illustrates results of high frequency capacitance-voltage (HFCV) measurements of FUSI devices on HfSiON with or without DyO layer cap layer.
Fig. 29 plots Id-Vg curves of HfSiON n-FET's with or without DyO cap layer for short channel devices (L_{g} =100nm).
Fig. 30 plots the threshold voltage (Vt,sat) as function of channel length (L_{g}) for n-FETs with HfSiON or DyO/HfSiON dielectrics.
Fig. 31 plots gate leakage (J_{G}) vs. channel length (L_{g}) for nFETs with HfSiON or DyO/HfSiON dielectrics.
Fig. 32 shows an XTEM of a NiSi/DyO(0.5nm)/SiON(2nm) gate after Source/Drain activation.
Fig. 33 shows results of HFCV measurements of nFETs NiSi/SiON with and without DyO cap layer.
Fig. 34 plots gate leakage (J_{G}) vs. channel length (L_{g}) for nFETs with SiON or DyO/SiON dielectrics.
Fig. 35 plots threshold voltage (Vt, sat) vs. channel length (L_{g}) for nFETs with SiON or Dy/SiON dielectrics.
Fig. 36 plots a comparison between the C-V curves for a reference wafer and the same wafer after selective DyO cap layer removal.
Fig. 37 plots gate current (Ig) versus gate voltage (Vg) of MIPS nFETS having dual gate dieletrics (on the same wafer).

### DESCRIPTION OF ILLUSTRATIVE EMBODIMENTS

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

In embodiments of the present invention, the term "substrate" may include any underlying material or materials that may be used, or upon which a device, a circuit or an epitaxial layer may be formed. In other alternative embodiments, this "substrate" may include a semiconductor substrate such as e.g. doped silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer.

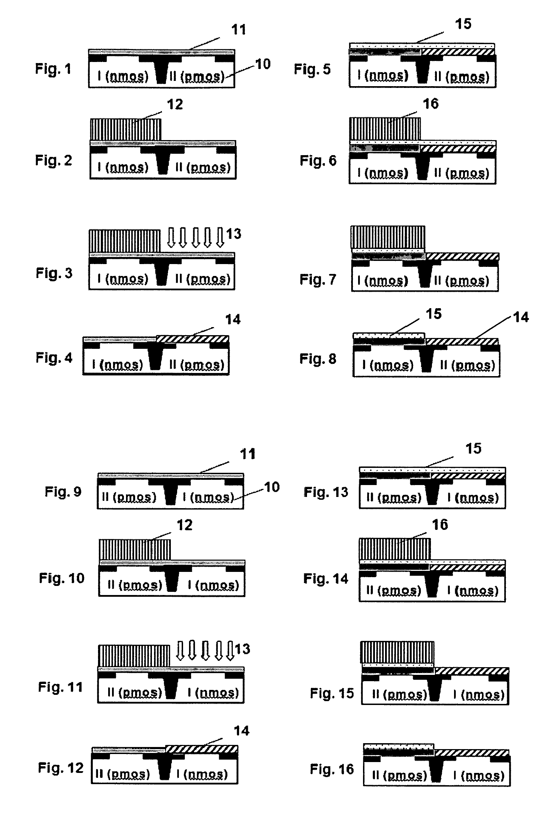

A substrate, e.g. a semiconductor substrate (10) comprises 2 different areas (N-MOS area I and P-MOS area II) and has an exposed surface. The exposed surface of the semiconductor substrate (10) comprises at least two different areas of a semiconductor material, which areas (I, II) are separated from each-other. These areas (I, II) are typically known as active areas, while the separation in-between is typically known as field insulation (LOCOS) or shallow trench insulation (STI). In one type of area (I), typically known as p-type active area, an N-MOS transistor is to be formed, while in the other type of area (II), typically known as n-type active area, a P-MOS transistor is to be formed. On the exposed surface of the substrate, a host gate dielectric (11) is deposited as shown in Figures 1 and 9. The host gate dielectric (11) can for example be SiO2, SiON; HfO2, HfSiO, HfSiON; ZrO2, ZrSiO, ZrSiON; a bilayer (like HfO2/SiO2), or a ternary dielectric, like HfZrO, HfZrSiO, HfLaO, HfLaSiO.

One type of the substrate areas may then optionally be covered with photoresist (12) as shown in Figures 2 and 10. In an exemplary embodiment, area (I) is covered with this photosensitive layer (12) in the embodiment illustrated by Figures 1-8 while the other area type (II) remains exposed. However, depending on the choice of the gate dielectric and the way the work function of the transistor gate is adjusted, e.g. ion implantation in the gate dielectric, intermediate layer between gate dielectric and gate electrode or a combination of both, one can choose to cover the other type of area (II) and have the one area (I) exposed as shown in the embodiment illustrated by Figures 9-16.

Next the host gate dielectric in the exposed area (II, I) is implanted with selected implantation species (13) as shown in Figures 3 and 11. Preferentially the ion implantation species for NMOS may include the lanthanides (Yb, La, Dy, Er, Gd, Sc, etc.), or one of the dopants like P, As, Sb or combinations thereof like (Yb +P). For PMOS the ion implantation species may include Al, O, Ru, Pt, W, Mo, B or combinations thereof like (A1 +B).

After implantation, the resist (12) is removed as shown in Figures 4 and 12 leaving behind on one of the areas (II, I) a dielectric layer with modified electrical properties (14) compared to the other dielectric layer (11) in the other area (I, II).

Next, as shown in Figures 5 and 13, optionally a high-k cap layer (15) may be deposited over both type of areas (I, II), i.e. on top of both the host dielectric layer (11) and the modified host dielectric layer (14). A high-k cap layer is a layer with a dielectric constant higher than that of SiO₂, i.e. higher than 4. The high-k cap layer (15) is then selectively removed from the area (II, I) covered with the modified host dielectric layer (14), for example by using a patterned photoresist mask (16) as shown in Figures 6 and 14 and a selective wet-etch process as shown in Figures 7 and 15.

Figures 8 and 16 show the final gate dielectric stack after removal of the photoresist (16). Both the selective wet-etch of the high-k cap layer (15) and the photoresist (16) removal are selected to meet the strong requirements of gate dielectric processing, such as integrity of the gate dielectric thereby substantially preserving its dielectric characteristics. These process steps are in more detail described in separate embodiments.

After provision of the final gate dielectric stacks, the gate electrode is provided on top of the final gate dielectric stacks. In accordance with embodiments of the present invention, a gate electrode is integrally provided onto both gate stacks at the first and second areas, respectively, thus providing gate electrodes with same properties, e.g. same electrode material, same electrode thickness, etc.

Further three methods for gate work function tuning, when forming a CMOS device with the same gate electrode material for N-MOS and P-MOS transistor, are disclosed in accordance with embodiments of the present invention. These methods can be used per se or in combination.

### (1) Work-function tuning by ion implantation into the host gate dielectric

The implantation (13) in the host gate dielectric (11) can be done before forming the gate electrode, e.g. a semiconductor gate electrode such as polycrystalline silicon or a metal gate electrode, as in Fig. 3 and in Fig. 11.

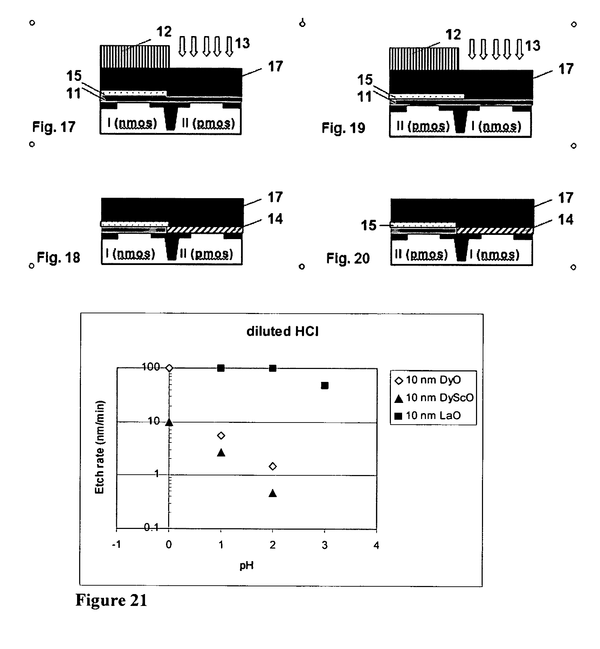

Alternatively the implantation (13) can be done through the unpatterned gate electrode, as in Fig. 17 and in Fig. 19. This means that the implantation can be performed before or after gate electrode formation. In the later case, the gate electrode (17) can consist of a single layer of electrode material, e.g. a semiconductor material or a metal, or can comprise a stack of layers, such as polysilicon with metal or a first metal with a second metal. In the latter case implantation through the gate electrode (17) into the host gate dielectric (11) can proceed either after the first layer of the stack is deposited on the host gate dielectric, or after a plurality of layers or even the total gate electrode stack is deposited.

The gate electrode can be either a semiconductor gate, such as a polysilicon gate, a metal gate with low implantation stopping power such that implanted species (13) can reach the host gate dielectric (11) even if low implant energy is used, a MIPS (polysilicon + metal gate stack), a fully silicided (FUSI) gate, or combinations of these different gate electrodes on N- and P-MOS respectively.

The method of tuning the work-function by ion implantation of the host gate dielectric (11) provides also a good way for equivalent oxide thickness (EOT) scaling as, e.g. a thicker host gate dielectric (11) can be formed with good electrical properties while the dielectric properties of this high quality host gate dielectric (11) are modified afterwards.

Photoresist is used as protective mask during the ion implantation process (13). After photoresist removal, a post-ion implantation annealing is preferably required. This anneal step has multiple purposes: 1) drive the implanted species to the targeted location for Vt tuning. This location can be either the host gate dielectric (11) or the interface between the gate electrode and the host dielectric (11); 2) facilitate the formation of the new gate dielectric (14) (as in Fig. 4, Fig. 12, Fig. 18 and Fig. 20); 3) repair the possible damages in the gate dielectric (14) after the ion implantation.

### (2) Work-function tuning by using a high-k dielectric cap layer between host gate dielectric and gate electrode

The cap layer (15) can be selectively deposited or selectively removed from the NMOS (I) or respectively, PMOS (II) area. Under suitable thermal budget (provided by junction spike or laser anneal, for example), the cap layer can either interact with the host dielectric to form an intermixing dielectric or can show no intermixing with the host dielectric. The cap layer may also react with the electrode material.

The cap layer may be an oxide from the La-family oxides (YbO, DyO, LaO, ErO, GdO) or ScO for NMOS; and AlO for PMOS. Ternary or quaternary oxides like DyScO, or combinations with Si or with N- incorporation (DyScON) are also considered.

The electrode can be either polysilicon gate, metal gate, MIPS (polysilicon + metal gate stack), fully silicided (FUSI) gate, or combinations of different gate electrodes on N- and P-MOS, separately. The method provides also a good way for EOT scaling.

The host gate dielectrics can be SiO2, SiON; HfO2, HfSiO, HfSiON; ZrO2, ZrSiO, ZrSiON; bi-layers (like HfO2/SiO2), or ternary dielectric, like HfZrO HfZrSiO.

### (3) Work-function tuning by ion implantation in the gate electrode prior to FUSI formation

By using ion implantation into a semiconductor gate electrode, and combined with both the thermal cycle and snow-plow effect during the FUSI process, the implanted species are pushed towards the interface between the gate electrode and host gate dielectric (11) where these implanted species react either with the host gate dielectric (11) or modify the interface between gate electrode and host gate dielectric. When forming a fully silicided gate electrode by forming a metallic alloy due to the reaction between a semiconductor material and a silicide-forming metal, the species implanted in the semiconductor gate experience a lower solubility in the metallic alloy formed compared to the unreacted semiconductor material. Hence the implanted species are moved in front of the metallic alloy formed. This phenomenon is known as snow-plow effect.

FUSI gate formation takes place through the reaction of poly-Si (a-Si, Si, SiGe, Ge), or doped poly-Si (a-Si, Si, SiGe, Ge) with one of the following metals: Ni, Co, Pt, NiPt, NiYb.

Preferentially the ion implantation species for NMOS may include the lanthanides (Yb, La, Dy, Er, Gd, Sc, etc.), or one of the dopants like P, As, Sb or combinations thereof like (Yb +P). For PMOS the ion implantation species may include Al, O, Ru, Pt, W, Mo, B or combinations thereof like (Al +B).

The host gate dielectrics can be SiO2, SiON; HfO2, HfSiO, HfSiON; ZrO2, ZrSiO, ZrSiON; bi-layers (like HfO2/SiO2), or ternary dielectric, like HfZrO, HfZrSiO, HfLaO, HfLaSiO.

### Examples

Further several specific integration methods are disclosed to fabricate CMOS FETs using dual dielectric layers, i.e. by forming different gate dielectric layers for N-MOS and P-MOS transistor respectively, by using the work function tuning methods of the previous paragraphs.

### Method 1: cap layer (15) on NMOS and ion implantation (13) on PMOS

Method 1 is illustrated in Figs 1 to 8. In Figure 1 a host dielectric (11) layer is deposited on a semiconductor substrate (10) comprising two different areas: (I) NMOS and (II) PMOS. The semiconductor substrate can for example be any of the following materials Si, SiGe, SOI, Ge, and III-V materials. The method can be applied to manufacturing of transistors with either planar or FinFET structure.

The host dielectric (11) may for example be one of the following SiON, HfSiON, HfO2, HfSiO, ZrO2, HfZrO, HfLaO, HfLaSiO. In a particular embodiment the host dielectric (11) is a thin SiON layer, with a thickness between 1- 20 Å.

The ion implantation species (13) for the PMOS area may be Al or O. No ion-implantation can be also an option, depending on the gate electrode choice, if a high-k cap layer (15) is formed on the NMOS area (I) in subsequent processing.

The high-k cap layer (15) is deposited on top of the host dielectric (11) and afterwards removed selectively from the PMOS area (II). The high-k cap layer (15) can be one of the following oxides: DyO, ScO, LaO, YbO, DyScO, DyYbO, DyLaO.

In a single gate electrode approach the gate electrode for both N-MOS and P-MOS transistor are integrally made, and thus have the same properties, i.e. a.o. are made from same material such as e.g. polysilicon, amorphous silicon or SiGe, Ni rich-FUSI, one of the following metal nitrides (TiN, TaN), metal carbides/carbo-nitrides (TaC, ,TaCN), metal oxi-(carbo)-nitrides (TaCNO, MoON, WON) or MIPS (one of the above metal electrodes with polysilicon cap layer on top), and having a same thickness.

Upon thermal annealing the final dielectric on the NMOS area (I) can be either a mix between the cap layer (15) and the host dielectric (11) or a stack consisting of two distinctive layers.

### Method 2: cap layer (15) on PMOS and ion implantation (13) on NMOS

Method 2 is illustrated in Figs 9 to 16. In Figure 9 a host dielectric (11) layer is deposited on a semiconductor substrate (10) comprising two different areas: (I) NMOS and (II) PMOS. The semiconductor substrate can for example be any of the following materials Si, SiGe, SOI, Ge, and III-V materials. The method can be applied to manufacturing of transistors with either planar or FinFET structure.

The host dielectric (11) may be for example one of the following SiON, HfSiON, HfO2, HfSiO, ZrO2, HfZrO, HfLaO, HfLaSiO. In a particular embodiment the host dielectric (11) is a thin SiON layer with the thickness between 1-20Å.

The ion implantation species (13) for the NMOS area (I) may be one of the following Yb, La, Dy, Er, Gd, Sc, P, As, Sb, No implantation can be also an option, depending on the gate electrode choice, if a high-k cap layer (15) is formed on the PMOS area (II) in subsequent processing.

The high-k cap layer (15) deposited on top of the host dielectric (11) and removed selectively from the NMOS area (I) can be AlO or AlN or a combination thereof like AlON. No cap can be an option depending on the choice of the gate electrode if an implantation is performed in the host gate dielectric (11) in the NMOS area (II) during previous processing.

In a single gate electrode approach the gate electrode for both N-MOS and P-MOS transistor are integrally made and thus have the same properties, i.e. a.o. are made from same material such as e.g. can be polysilicon, amorphous silicon or SiGe, Ni rich -FUSI, one of the following metal nitrides (TiN, TaN), metal carbides/carbo-nitrides (TaC, TaCN), metal oxi-(carbo)-nitrides (TaCNO, MoON, WON) or MIPS (one of the above metal electrodes with poly capping layer on top), and having a same thickness.

Upon thermal annealing the final dielectric on the PMOS area (II) can be either a mix between the cap layer (15) and the host dielectric (11) or a stack consisting of two distinctive layers.

### Method 3: cap layer (15) on PMOS and cap layer (15') on NMOS

A third method which is a combination of method 1 and method 2 is also provided. The method uses a first high-k cap layer for the NMOS area (I) as in method 1 and a second, different, high-k cap layer for the PMOS area (II) as in method 2. In this embodiment the cap layers are formed selectively on the NMOS (I) and PMOS (II) area respectively. This can be done e.g. by depositing a first cap layer and selectively removing this first cap layer from one area, e.g. NMOS (I), followed by the depositing of a second cap layer and selectively removing this second cap layer from the first cap layer in the other area, e.g. PMOS (II). In this embodiment no implantation is used, the targeted work functions are obtained by using two different cap layers for the NMOS (I) and PMOS (II) area, respectively.

The materials choice for the substrate, the host dielectric (11), the cap layers (15) and the gate electrode are according to method 1 and method 2.

### Single FUSI gate electrode - dual dielectric process integration flow

In a particular embodiment, a simplified method for CMOS integration is described. The method is suitable for a wide Vt range, inclusive high performance applications (low Vt). The method uses a high-k cap layer on top of a host dielectric layer on the NMOS devices and a single-phase Ni-rich FUSI electrode formed simultaneously on both NMOS and PMOS devices.

The method takes advantage of the fact that by use of a thin high-k cap layer (e.g., DyO, ScO, LaO) on top of the host gate dielectric, the work function (WF) can be modulated such that low-Vt n-type electrode can also be achieved with a Ni-rich FUSI. The host gate dielectric may for example be one of the following materials: Si02, SiON or high-k materials such as HfSiON. With high-k dielectric is meant a dielectric having a dielectric constant which is higher than the dielectric constant of Si02, i.e. higher than 4. The dielectric constant of such high-k dielectric is preferably in the range of 10 to 40, preferably 15 to 30.

Results of an embodiment using a DyO cap layer on the NMOS devices and a single phase Ni-rich FUSI gate electrode are given hereinbelow.

In the CMOS integration flow proposed, the high-k cap layer 15 is selectively removed from the PMOS devices as in Fig. 1-8, and a Ni-rich FUSI phase is afterwards simultaneously formed for NMOS and PMOS devices. The selective removal of the high-k cap layer and the subsequent photoresist strip make the object of a separate embodiment of this invention.

Further gate work function modulation (for p or n-type devices with Ni-rich FUSI gate electrodes) can be achieved by means of implantation of workfunction-tuning elements into the dielectric layers of devices not covered by a capping layer, such as for example Al for PMOS or P/Yb for NMOS. Pre- and/or post high-k cap deposition nitridation conditions tuning can also be used for further tuning the work function.

A further advantage of the single phase FUSI (Ni-rich) gate electrode for both NMOS and PMOS devices is that it eliminates the potential problems at the boundary between NMOS gate electrode and PMOS gate electrode when a dual-phase FUSI CMOS scheme is used. With a silicide phase, a predetermined type of a particular metal silicide is meant, i.e. metal rich (silicon poor) or metal poor (silicon rich) silicide. In the case of dual-phase FUSI, the length of the interface region between NiSi (NMOS) and Ni-rich (PMOS) gate electrodes can be of concern for very high density applications. In case of the single phase FUSI electrode for both NMOS and PMOS as in embodiments of the present invention, this interface problem is solved.

The use of a Ni-rich phase FUSI for both NMOS and PMOS also leads us to a higher process window for the FUSI CMOS integration process, hence with further advantages for manufacturability.

### Experiment

Short channel nFET devices with NiSi or Ni₃₁Si₁₂ FUSI gate were fabricated using a self-aligned CMP-based approach. Optimized MOCVD HfSiON (2.3nm) or thermal SiON (2 nm) was deposited as host dielectrics. An ultra-thin DyO cap layer (5Å) was then deposited by AVD® using Dy(EDMDD)3 and O2 precursors at 550°C. MOSCAPs with slant etching SiO2 surface (3-7nm) were used to evaluate the eWF of both NiSi or Ni2Si FUSI with 5 or 10Å DyO.

### HfSiON with DyO cap layer

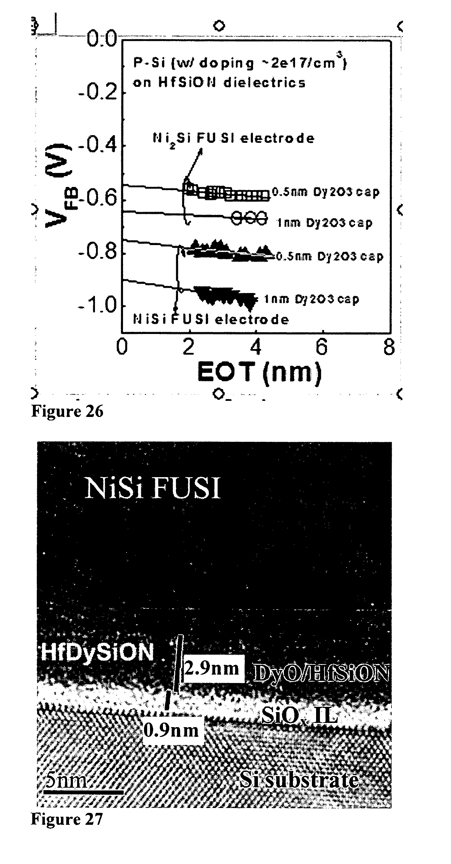

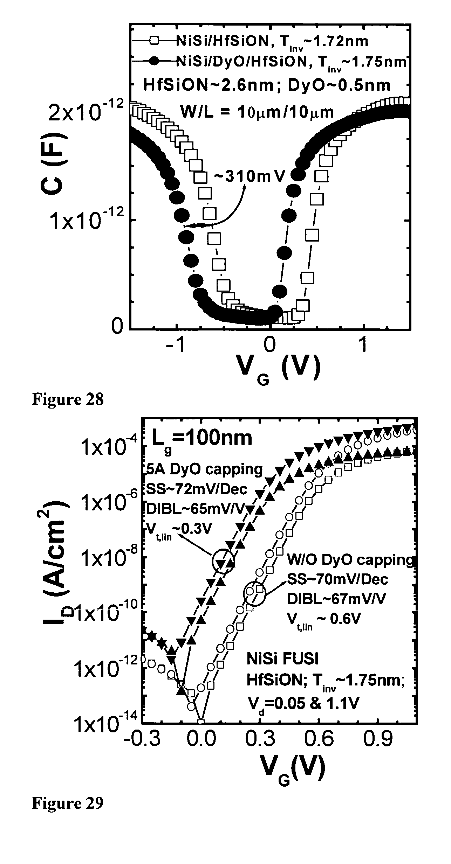

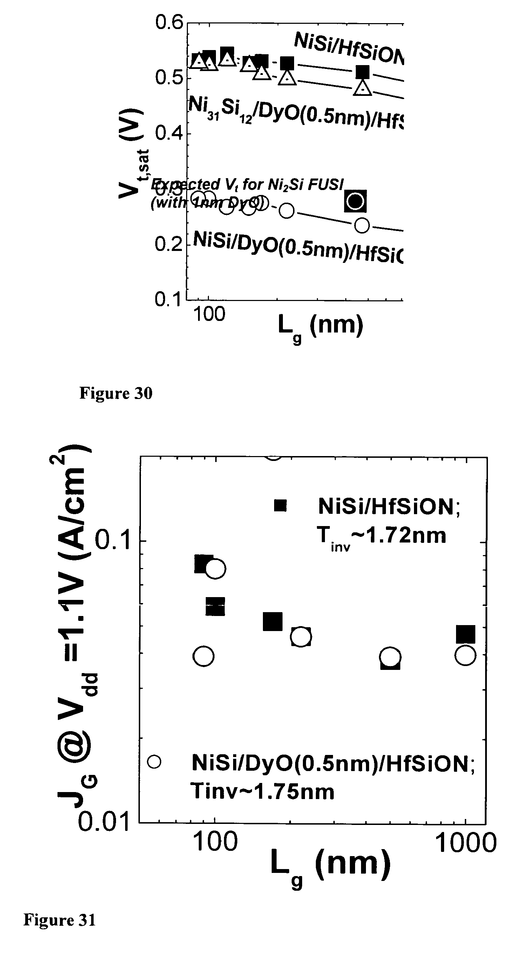

From the plot of V_{fb} vs. EOT (Fig.26), it can be seen that with a DyO cap layer the effective WF of Ni FUSI on HfSiON is modulated towards Si conduction band edge, depending on the DyO thickness and the phase of Ni silicide. In Fig.27, an XTEM of FUSI/DyO/HfSiON gate stack indicates the complete intermixing between HfSiON and DyO after full device fabrication. Using high frequency capacitance-voltage (HFCV) measurements (Fig.28), the thickness Tinv of the HfSiON or DyO/HfSiON dielectrics is determined to be ~1.72nm or 1.75nm respectively. Well-behaved short channel devices (Lg= 100nm) drain current versus gate voltage (Id-Vg) curves are demonstrated in Fig.29 with good subtreshold slope (*SS*) of ~70mV/Dec for both HfSiON and DyO/HfSiON devices with NiSi FUSI electrode. In addition, both devices exhibit a similar Drain Induced Barrier Lowering (DIBL) value (~65mV/V), suggesting their good short channel effect. It has been observed that applying the DyO cap results in a threshold voltage (Vt) reduction of the NiSi FUSI devices with 300mV, corresponding to their CV data (Fig.28). In Fig.30, the devices with DyO/HfSiON stack maintain a similar Vt roll-off characteristics to the reference HfSiON devices. The Vt, of the long channel devices (with channel length Lg=1µm) with NiSi/DyO/HfSiON stack is 0.22V, satisfying the low Vt requirement.
It is well known that Ni rich FUSI is a good pFET electrode candidate due to its high work function (WF) especially on HfSiON. It is thus interesting to note that in Fig.30, with a 5Å DyO cap layer, the Vt of Ni₂₁Si₁₂ FUSI nFETs turns out to be ~30m V lower than that of NiSi FUSI. In the same figure, if one uses a 1nm DyO cap, the Vt of a Ni2Si FUSI nFET is predicted to be ~0.35V. In combination with N or F channel implantation, this data demonstrates the feasibility to realize low Vt FUSI/HfSiON CMOS using a single phase Ni2Si gate. In Fig.31, no mobility or gate leakage (inversion) degradation is observed when using a DyO cap on HfSiON for all the devices with various Lg.

### SiON with DyO cap layer

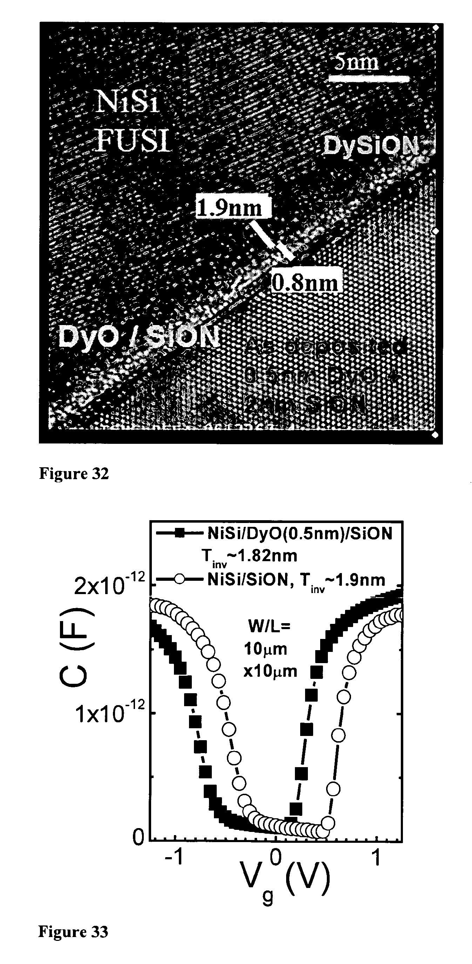

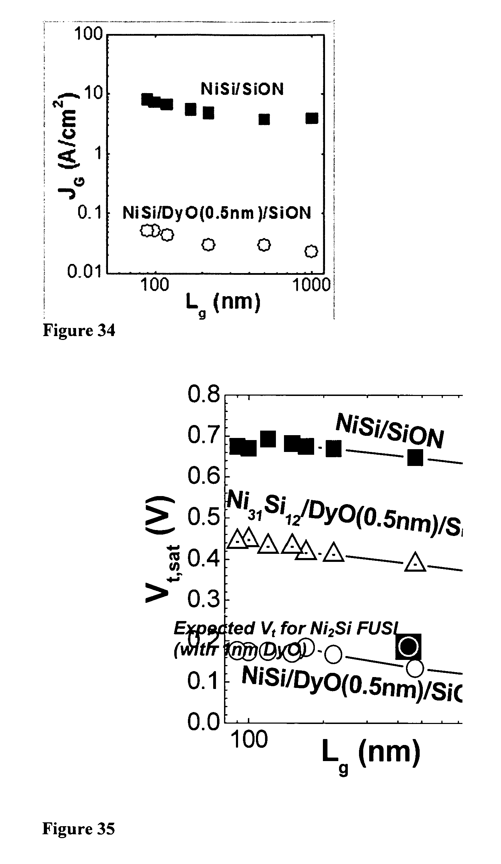

The XTEM (Fig.32) of DyO/SiON suggests a new DySiON silicate formation after full device fabrication. The extent of WF lowering of Ni FUSI on SiON using DyO cap relies on the cap thickness and silicide phase (inset of Fig.32). From HFCV of nFETs (Fig.33), it is interesting to note the DyO cap leads to a reduction of SiON thickness Tinv by ~0.8Å, contrasting to the HfSiON case. From Fig.34, it can be seen that the DyO cap significantly reduces the gate leakage J_{G} (@Vdd=1.1V) compared to SiON (by ~150x) despite of its slightly thinner thickness Tinv. As can be seen from Fig.35, DyO cap does not degrade the threshold voltage (Vₜ) roll-off characteristics as compared to the reference SiON nFETs. With 5Å DyO cap, the nFET Vt,lin with NiSi/Ni31Si12 FUSI gate is 0.18V/0.38V respectively (channel length Lg=1µm). Considering Fig.32, the Vt of devices with 1nm DyO cap and with Ni2Si FUSI gate is predicted to be ~0.28V. Combining the process of Al pre-doping for p-FETs or channel N/ F implantation, this data shows it is viable to realize low Vt FUSI/SiON CMOS using single phase Ni₂Si gate.

### Selective wet etch of the high-k cap layer

In this embodiment , a wet etch solution is proposed that can remove DyO or DyScO based cap layers selectively towards underlying host dielectrics such as HfO, HfSiONx, HfDyOx, HfScOx. Similar oxides from Lanthanides (including LaO) could be selectively removed with the proposed solution as well.

Different materials could be selected as protective mask for the selective removal process. In this specific embodiment photoresist is used as protective mask, since photoresist can be removed with good selectivity towards both the remaining cap layer (15) and the exposed host dielectric (11, 14).

The high-k cap layer (15) is deposited on top of the host dielectric (11). In this way the whole substrate (10) is covered with the high-k cap layer. Photoresist (16) is coated in a standard way. Thereafter the resist (16) is removed from the wafer areas where later on the high-k cap layer (15), e.g. DyO, should be removed. The remaining resist is used as a protective mask for the DyO cap layer (15) etching/removal. The DyO removal chemistry is selected to leave the photoresist (16) protective mask intact so that a good definition/transfer of the resist pattern to the cap layer (15) is ensured and to be selective towards the underlying host dielectric layer (11), because very minor thickness variation can cause big variations in k-value. After the DyO removal, the patterned resist protective layer (16) should be removed. This resist removal process is selected to be selective to the host dielectric material (11) and the high-k cap layer (15).

### Higk-k cap layer (DyO) removal

In a specific embodiment use is made of low pH solutions to selectively remove DyO-based cap layers (15) (see Figure 21) from HfO₂, HfSiO, HfSiON or similar high-k layers. Figure 17 shows the etch rate of DyO, DyScO and LaO in acidified solutions.

Acids, such as diluted HCl solutions, have been evaluated but the embodiments described herein are not restricted to the use of HCl based solutions. Other diluted acids can be used such as HNO3, H3PO4, H2SO4, HBr, acetic acid, formic acid, propionic acid.

As an example, the HCl dilution used to demonstrate the concept, was 1 part of HCl in 9 parts of water. This means a concentration of about 3.6 w/w %, or about 1.2 M (mol/l) or a pH of about 0. The useful concentration range can be broader and the pH range should be between pH 0 - pH 5, more preferably between pH 0 - pH 4. In the experiments the temperature was 25°C, but other temperatures will work as well. Lower temperature might decrease the reaction speed, while increased temperatures accelerate the high-k cap layer removal.

Experiments on DyO removal have been done both in beakers and in a commercially available single wafer spray tool. The method should, however, not be limited to these tool types or categories but could also be used in batch spray processors or re-circulating baths.

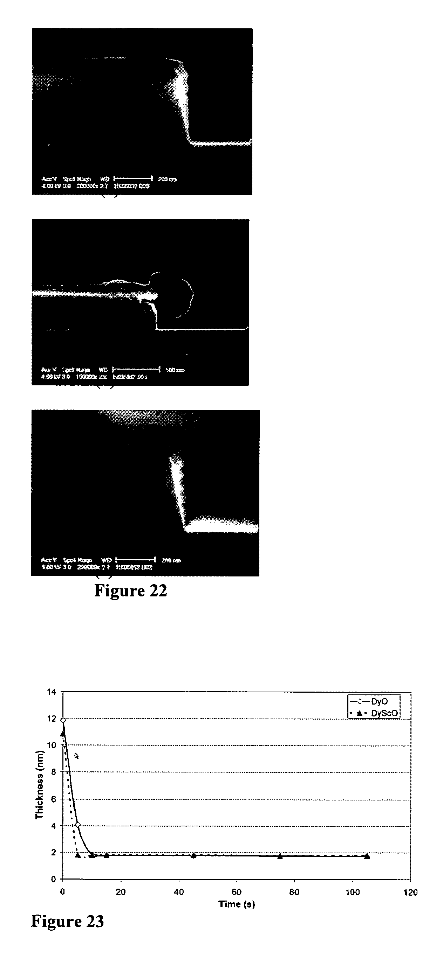

Diluted HF could also be used to remove DyO (if needed in combination with another acid) but cannot be used in an integration approach in accordance with embodiments of the present invention, since this can cause pattern integrity loss of the resist hardmask and also attacks the underlying host dielectric if Hf-based high-k's are used. HCl and HF/HCl (0.03M / 1.2M) solutions were checked on a single wafer tool with regard to their compatibility with DUV resist. Figure 22 shows the compatibility of DUV (deep ultraviolet) resist with HCl and HF/HCl chemistry. Figure 18(a) shows a cross-section SEM of a non-treated resist feature, i.e. after lithographic patterning and before exposing to wet etchant, 18(b) a HF/HCl treated resist feature, and 18(c) a HCl treated resist feature. It is obvious that after the HF/HCl process, resist pattern loss is observed. Top-view SEM inspections have also been performed and had the same outcome. This indicates the limited use of HF as etching mixture.

Figure 23 summarizes the etch rates for DyO removal. The etch rate experiments were performed on a single wafer spin processor tool with HCl (3.6 w/w %) at a temperature of 25°C. The recipe sequence was diluted HCl (dHCl) exposure, water rinse, spin dry. As can be observed, the DyO layer is easily removed in dHCl. The etch rate is relatively high and more diluted HCl would decrease the etch rate to a more reliable and manufacturable value, as can be learned from the data shown in Figure 17.

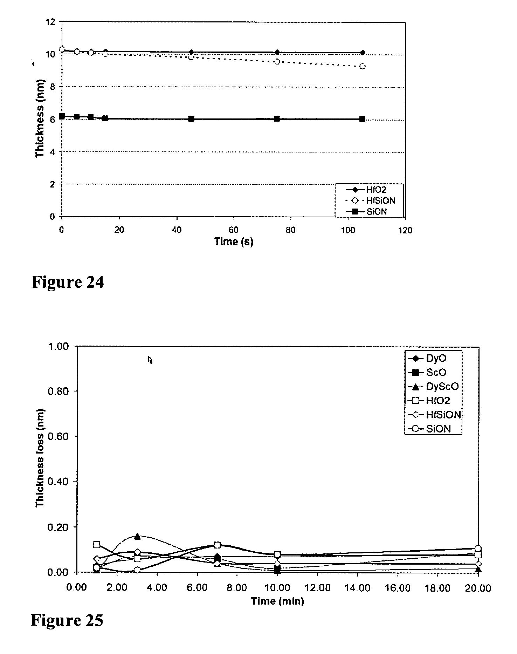

The solution used to remove the DyO should leave the host dielectric layer substantially intact. Different host dielectric layers (HfO2, HfSiON, SiON) were exposed to a diluted HCl (3.6 w/w %) solution at a temperature of 25C. The results are summarized in Figure 24. The tested host dielectric layers remain essentially untouched resulting in excellent selectivities as summarized in Table 1.

**Table 1: Selectivity of high-k cap layer removal towards different host dielectrics using 3.7 w-% HCl solution and photoresist hardmask.**

| | Host dielectric: | | |
|---|---|---|---|
| Cap: | HfO₂ | SiON | HfSiON |
| DyO | 2000 | 850 | 460 |
| DyScO | >3600 | >1500 | >180 |

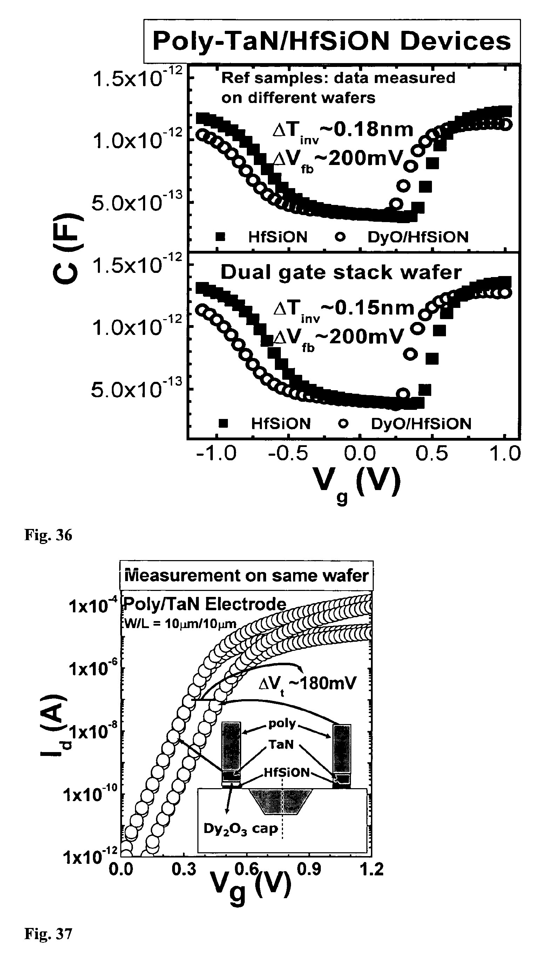

Fig.36 reveals a similar Vfb & Tinv variation by comparing nFETs after selective DyO cap removal to reference wafers (i.e. nFETs with fresh HfSiON or fresh DyO/HfSiON without any selective wet etching process). Regarding to the nFETs with dual gate dielectrics, Fig.37 shows a Vt reduction of ~180mV due to DyO cap layer, consistent with the CV data (Fig.36).

### Photoresist removal

The industry standard SPM cleaning solutions cannot be used because they have a very low pH. This is, as learned from the above, ideal to remove DyO which is unwanted in this step.

A neutral or alkaline pH aqueous stripper or a non-aqueous stripping solution is preferably used. In case of a neutral or alkaline pH aqueous stripping solution, an oxidizing component needs to be present to oxidize the photoresist and to solubilize it. In embodiments of the present invention, the use is claimed of organic based solvent strippers. The resist can be dissolved in many solvents and a tentative list includes, but not limited by, 1-methoxy-2-propanol, 2-butanol, Acetonitrile, Acetylaceton, Cyclohexanon, Dimethylsulfoxide (DMSO), Ethylacetaat, Methylisobutylketon (MIBK), N-ethylpyrrolidon (NEP), N-methylpyrrolidon (NMP), Tetrahydrofuran (THF), Tetrahydrofurfurylalcohol (THFA).

Such resist stripper formulations are commercially available (e.g. Microstrip 2001 from Fujifilm). In the present invention, this resist stripper formulation has been used, as an example, it undiluted in a beaker setup and heated at 80°C. Other approaches at higher temperature will probably work as well. The sequence used was Microstrip 2001 dip, 10 minute water rinse and Marangoni dry.

With top view SEM the resist removal rate has been examined and it has been observed that resist was completely removed within 1 minute. To establish a process window, the compatibility of the host dielectric and high-k cap layers with this chemistry was examined. The results for Microstrip 2001 at 80C (beaker set-up) are shown in Figure 25. In a time frame of 20 minutes almost no thickness reduction (loss) is observed for any of the layers tested. Since resist removal is complete in less than 1 minute, this allows enough overetching of the resist without compromising the host dielectric or the high-k cap layer.

The resist removal can be done in a static tank but also in re-circulating baths and on single wafer or batch spray processors. To enhance the resist cleaning efficiency, a physical removal force such as by megasonic irradiation or liquid jet spray (e.g. NanoSpray - thermal spraying of nanostructured materials) can be used during the resist removal process.

In addition, after removal of the resist by an organic solvent, an additional aqueous based (low or alkaline pH) cleaning solution can be used to further remove residual contamination from either the resist or the solvent from the wafer surface. Such an aqueous based cleaning solution can comprise of NH₄OH/H₂O₂/H₂O mixtures at room temperature or elevated temperature. This can be done in a static tank but also in re-circulating baths and on single wafer or batch spray processors. To enhance the cleaning efficiency, a physical removal force such as by megasonic irradiation or liquid jet spray (e.g. NanoSpray) can also be used during this process.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the spirit of the invention.

## Claims

1. Method for manufacturing a dual workfunction semiconductor device, comprising providing a device on a first region and a device on a second region of a substrate by
- providing a dielectric layer onto the first and second region of the substrate, the dielectric layer on the first region being integrally deposited with the dielectric layer on the second region, and
- providing a gate electrode on top of the dielectric layer on both the first and second regions, the gate electrode on the first region being integrally deposited with the gate electrode on the second region,
the method further comprising
changing the workfunction of the device on the first region by providing a capping layer onto the first region between the dielectric layer and the gate electrode, and
changing the workfunction of the device on the second region by including species at the interface between the dielectric layer and the electrode.

2. Method according to claim 1, wherein the device on the first region is an N-MOS device.

3. Method according to any of the previous claims, wherein the device on the second region is a P-MOS device.

4. Method according to any of the previous claims, wherein including species at the interface between the dielectric layer and the electrode is performed before providing the gate electrode on top of the dielectric layer.

5. Method according to any of claims 1 to 3, wherein including species at the interface between the dielectric layer and the electrode is performed after electrode formation.

6. Method according to any of the previous claims, furthermore comprising providing a capping layer onto the second region between the dielectric layer and the gate electrode.

7. Method according to claim 6, furthermore comprising providing a further capping layer for protecting the gate integrity.

8. Method according to any of the previous claims, wherein including species at the interface between the dielectric layer and the electrode comprises introducing species by ion implantation.

9. Method according to claim 8, wherein introducing species by ion implantation comprises providing a resist layer on specific locations of the dielectric layer, and performing ion implantation in regions not covered by the resist layer.

10. Method according to any of the previous claims, further comprising tuning of pre and/or post capping layer deposition nitridation conditions for further tuning the workfunction of the semiconductor device.

11. Method according to any of the previous claims, wherein capping is performed by means of DyOx

12. Method according to claim 11, furthermore comprising removing the capping layer by means of a selective wet etch.

13. Method according to claim 12, wherein the selective wet etch is performed by means of a low-pH solution with a pH lower than 5.

14. Method according to any of the previous claims, wherein the gate electrode is a FUSI electrode.

15. A dual workfunction semiconductor device, comprising semiconductor devices of a first type and semiconductor devices of a second type, each semiconductor device comprising:
- a gate dielectric on a substrate, and
- a gate electrode on the gate dielectric,
wherein the gate electrodes of the semiconductor devices of the first type are integrally made with the gate electrodes of the semiconductor devices of the second type, and
wherein the gate dielectric of the semiconductor devices of the first type is integrally made with the gate dielectric of the semiconductor devices of the second type but includes different species at the interface between the gate dielectric and the gate electrode.

## Amended claims

### Amended claims in accordance with Rule 137(2) EPC.

**1.** Method for manufacturing a dual workfunction semiconductor device, comprising providing a device on a first region and a device on a second region of a substrate by
- providing a dielectric layer onto the first and second region of the substrate, the dielectric layer on the first region being integrally deposited with the dielectric layer on the second region, and
- providing a gate electrode on top of the dielectric layer on both the first and second regions, the gate electrode on the first region being integrally deposited with the gate electrode on the second region and both the gate electrode on the first region and the gate electrode on the second region having a workfunction,
the method further comprising
changing the workfunction of the gate electrode on the first region by providing a capping layer onto the first region between the dielectric layer and the gate electrode and not onto the second region, and
changing the workfunction of the gate electrode on the second region by implanting species to introduce these species at the interface between the dielectric layer and the gate electrode in the second region and not in the first region.

**2.** Method according to claim 1, wherein the device on the first region is an N-MOS device.

**3.** Method according to any of the previous claims, wherein the device on the second region is a P-MOS device.

**4.** Method according to any of the previous claims, wherein implanting species at the interface between the dielectric layer and the gate electrode is performed before providing the gate electrode on top of the dielectric layer.

**5.** Method according to any of claims 1 to 3, wherein implanting species at the interface between the dielectric layer and the gate electrode is performed after gate electrode formation.

**6.** Method according to any of the previous claims, wherein implanting species comprises providing a resist layer on specific locations of the dielectric layer, and performing ion implantation in regions not covered by the resist layer.

**7.** Method according to any of the previous claims, wherein providing a capping layer is performed by providing a DyOx capping layer.

**8.** Method according to claim 7, furthermore comprising removing the capping layer by means of a selective wet etch.

**9.** Method according to claim 8, wherein the selective wet etch is performed by means of a low-pH solution with a pH lower than 5.

**10.** Method according to any of the previous claims, wherein the gate electrode is a FUSI gate electrode.

**11.** A dual workfunction semiconductor device, comprising devices of a first type and devices of a second type, each device comprising:
- a gate dielectric on a substrate, and
- a gate electrode on the gate dielectric, the gate electrode having a workfunction,
wherein the gate electrodes of the devices of the first type are integrally made with the gate electrodes of the devices of the second type, and wherein the gate dielectric of the devices of the first type is integrally made with the gate dielectric of the devices of the second type and wherein the dual workfunction semiconductor device furthermore comprises a capping layer in between the dielectric layer and the gate electrode of the devices of the first type and not in devices of the second type and implanted species at the interface between the dielectric layer and the gate electrode of the devices of the second type and not of the first type.
